# EUROPÄISCHE PATENTANMELDUNG

(11) **EP 3 873 184 A1**
(43) Veröffentlichungstag der Anmeldung: **01.09.2021**
(21) Anmeldenummer: 21159301.7
(22) Anmeldetag: 25.02.2021
(51) Int. Cl.: H05K 7/14, H01L 21/673, H05K 13/00, H01L 21/677

(54) **SUBSTRATMAGAZIN FÜR BE- ODER ENTLADEEINRICHTUNGEN**

(30) Priorität: 25.02.2020 DE 202020101033 U
(71) Anmelder: Asys Automatisierungssysteme GmbH, 89160 Dornstadt (DE)
(72) Erfinder: Lehner, Jürgen, 89150 Laichingen (DE); Mang, Klaus, 89143 Blaubeuren (DE)
(74) Vertreter: Clarenbach, Carl-Philipp

(57) **Zusammenfassung**

Substratmagazinsystem (1) für Be- oder Entladeeinrichtungen von Fertigungslinien, mit zumindest einem Substratmagazin (2), das zwei beabstandet zueinander angeordnete und parallel zueinander ausgerichtete Seitenwände (13,14) aufweist, zwischen denen eine Vielzahl von Schubfächern (15) übereinanderliegend ausgebildet ist, wobei die Schubfächer (15) jeweils zur Lagerung einer oder mehrerer flächiger Substrate (18) ausgebildet sind, und wobei jedes Schubfach (15) durch jeweils zwei Führungsschienen (16,17) ausgebildet ist, die an den Seitenwänden (13,14) beabstandet zueinander einander gegenüberliegend angeordnet sind, wobei zumindest eine der Seitenwände (14) zum Verändern der lichten Weite zwischen den Seitenwänden (13,14) verschiebbar gelagert ist, und mit zumindest einer Substrathandhabungseinrichtung (3) in, an oder auf welcher das zumindest eine Substratmagazin (2) zur Handhabung von Substraten (18) anordenbar ist. **Es ist vorgesehen**, dass die Substrathandhabungseinrichtung (3) einen ersten Aktuator (28) aufweist, der mit der verschiebbar gelagerten Seitenwand (14) durch eine betätigbare Kupplung (34) koppelbar und dazu ausgebildet ist, die verschiebbare Seitenwand (14) im gekoppelten Zustand zu verschieben.

## Beschreibung

Die Erfindung betrifft ein Substratmagazin für Be- oder Entladeeinrichtungen von Fertigungslinien, mit zumindest einem Substratmagazin, das zwei beabstandet zueinander angeordnete und parallel zueinander ausgerichtete Seitenwände aufweist, zwischen denen eine Vielzahl von Schubfächern übereinanderliegend ausgebildet ist, wobei die Schubfächer jeweils zur Lagerung einer oder mehrerer flächiger Substrate, wie beispielsweise Leiterplatten, insbesondere Rohlinge, Solarzellen oder Wafer, ausgebildet sind, und wobei jedes Schubfach durch jeweils zwei Führungsschienen ausgebildet ist, die an den Seitenwänden beabstandet zueinander einander gegenüberliegend angeordnet sind, wobei zumindest eine der Seitenwände zum Verändern der lichten Weite zwischen den Seitenwänden verschiebbar gelagert ist, und mit zumindest einer Substrathandhabungseinrichtung in, an oder auf welcher das zumindest eine Substratmagazin zur Handhabung von Substraten anordenbar ist.

Substratmagazinsysteme der eingangs genannten Art sind aus dem Stand der Technik bekannt. Für die Handhabung von Substraten in Fertigungslinien werden Substratmagazine eingesetzt, um Substrate vor der Bearbeitung, beispielsweise in Form von Substratrohlingen bereitzustellen, während der Bearbeitung beispielsweise für den Transport zwischenzulagern und nach der Bearbeitung für die weitere Verwendung oder Verarbeitung zu lagern. Substratmagazine dienen dazu, eine Vielzahl von Substraten gleichzeitig aufzunehmen, sodass bei einem Transport des Substratmagazins alle darin befindlichen Substrate mittransportiert werden können. Bei flächigen Substraten werden diese regelmäßig in Schubfächer eines Substratmagazins eingeschoben, wodurch eine Vielzahl von Substraten in einem Substratmagazin aufbewahrt werden können. Insbesondere können auch mehrere Substrate nebeneinanderliegend in ein Schubfach eingeschoben werden. Um sicherzustellen, dass Substratrohlinge oder bereits bestückte oder bearbeitete Substrate nicht beschädigt werden, werden die Substrate nur an zwei voneinander abgewandten Seitenrändern in dem jeweiligen Schubfach durch die Führungsschienen gehalten, sodass das jeweilige Substrat nur an seinem Außenrand auf einer Führungsschiene aufliegt. Dadurch ist gewährleistet, dass auf dem Substrat befindliche elektrische/elektronische Bauteile durch die Lagerung nicht beschädigt werden.

Substrathandhabungseinrichtungen, wie beispielsweise Be- und Entladeeinrichtungen oder Transporteinrichtungen dienen dazu, ein oder mehrere Substratmagazine aufzunehmen und automatisiert Substrate zu entnehmen oder in das Substratmagazin einzuführen oder das Substratmagazin insgesamt zu transportieren. Aus der noch nicht veröffentlichten Patentanmeldung DE 10 2019 211 603 ist bereits ein Substratmagazin bekannt, das außerdem eine verschiebbare Seitenwand aufweist, um den Abstand der Seitenwände zueinander beziehungsweise die lichte Weite zwischen den Seitenwänden zu verändern, wodurch die Breite der Schubfächer veränderbar ist, um das Substratmagazin zur Aufnahme von Substraten mit unterschiedlicher Breite anzupassen.

Der Erfindung liegt die Aufgabe zugrunde, ein verbessertes Substratmagazinsystem zu schaffen, durch welches eine verbesserte Handhabung von Substraten, insbesondere eine verbesserte Handhabung von unterschiedlichen Substraten, beispielsweise in unterschiedlichen Bestückungslinien, durch ein und dasselbe Substratmagazin ermöglicht ist. Dadurch kann eine Widerverwendung und Weiterverwendung eines Substratmagazins für einen Betrieb verbessert und damit beispielsweise die Gesamtanzahl von notwendigen Substratmagazinen reduziert werden.

Die der Erfindung zugrundeliegende Aufgabe wird durch ein Substratmagazinsystem mit den Merkmalen des Anspruchs 1 gelöst. Dieses hat den Vorteil, dass das zumindest eine Substratmagazin automatisiert an aufzunehmende Substrate anpassbar ist. Dabei erfolgt das Anpassen des Substratmagazins durch einen externen Aktuator, sodass der Aktuator selbst nicht mit dem Substratmagazin mitbewegt werden muss, wodurch sich zum einen Vorteile bezüglich des Gewichts des Substratmagazins und zum anderen auch bezüglich des Bauraums des Substratmagazins ergeben. Darüber hinaus ist dadurch eine rein mechanische Ausbildung des Substratmagazins ermöglicht, weil der Aktuator und damit die zum Ansteuern des Aktuators gegebenenfalls vorhandene Steuerelektronik ebenfalls extern ausgelagert ist. Erfindungsgemäß ist hierzu vorgesehen, dass die Substrathandhabungseinrichtung einen ersten Aktuator aufweist, der mit der verschiebbar gelagerten Seitenwand durch eine betätigbare Kupplung koppelbar und dazu ausgebildet ist, die Seitenwand im gekoppelten Zustand zu verschieben. Der Aktuator ist somit extern auf der Substrathandhabungseinrichtung angeordnet und ist durch die Kupplung mit der verschiebbar gelagerten Seitenwand zu deren Verschiebung koppelbar. Damit erfolgt das Anpassen des Substratmagazins an insbesondere unterschiedliche Substratbreiten automatisiert nicht durch das Substratmagazin selbst, sondern durch die Substrathandhabungseinrichtung.

Damit ist ein einfacher konstruktiver Aufbau des Substratmagazins, wie zuvor bereits beschrieben, ermöglicht.

Gemäß einer bevorzugten Weiterbildung der Erfindung weist das Substratmagazin einen der verschiebbar gelagerten Seitenwand zugeordneten Spindelantrieb auf, der durch die Kupplung mit dem Aktuator koppelbar ist. Durch den Spindelantrieb ist ein einfaches und genaues Verlagern der verschiebbar gelagerten Seitenwand gewährleistet. Der Spindelantrieb weist beispielsweise eine Antriebsspindel auf, die sich in Verschieberichtung der Seitenwand erstreckt, sowie eine Spindelmutter oder ein Spindelgewinde, das mit einem Außengewinde der Antriebsspindel in Eingriff steht und drehfest an der Seitenwand angeordnet ist. Wird nunmehr die Antriebsspindel gedreht, wird die Drehbewegung der Antriebsspindel in eine translatorische Schiebebewegung der Seitenwand übersetzt. Die Seitenwand ist insbesondere an einem Rahmen des Substratmagazins verschiebbar gelagert, beispielsweise mithilfe eines Schienen- oder Führungsstangensystems. Der Spindelantrieb ist eine rein mechanische Einrichtung, die in dem Substratmagazin integriert ist. Durch die Kopplung mit dem ersten Aktuator mittels der Kupplung ist der Spindelantrieb antreibbar und damit die Seitenwand verlagerbar. Hierdurch ergibt sich eine einfache und kostengünstige Realisierung der Seitenwandverschiebung.

Besonders bevorzugt weist der Spindelantrieb die bereits genannte Antriebsspindel auf, die an einem freien Ende ein erstes Kupplungselement aufweist, wobei der erste Aktuator eine Antriebswelle aufweist, die an einem freien Ende ein zweites Kupplungselement aufweist, wobei das erste und das zweite Kupplungselement zusammen die betätigbare Kupplung ausbilden. Durch die Anordnung der Kupplungselemente an der Antriebsspindel sowie an der Antriebswelle wird eine direkte Verbindung zwischen Aktuator und Spindelantrieb gewährleistet, der bauraumsparend und verschleißarm ist.

Vorzugsweise ist zumindest eines der Kupplungselemente verlagerbar zum Herstellen und Lösen der Kupplung ausgebildet. So ist durch das Verlagern des einen Kupplungselements eine Wirkverbindung zu dem anderen Kupplungselement herstellbar und lösbar, je nachdem, ob das verlagerbare Kupplungselement in Richtung des einen Kupplungselements oder davon wegbewegt wird. Durch die verlagerte Anordnung der Kupplungselemente ist ein einfaches mechanisches Wirkverbinden des Aktuators mit der Seitenwand, insbesondere mit dem Spindelantrieb, gewährleistet.

Besonders bevorzugt ist in dem verlagerbaren Kupplungselement ein zweiter Aktuator zu dessen Verlagerung angeordnet. Dadurch ist sichergestellt, dass das Koppeln unabhängig von dem Antrieb zur Verlagerung der Seitenwand erfolgt und jederzeit ein Lösen der Kopplung unabhängig von dem Antrieb der Seitenwand möglich ist. Dies erfüllt insbesondere Sicherheitsvorkehrungen, die bei einer Fehlfunktion des ersten Aktuators greifen. Wird beispielsweise eine Fehlfunktion des ersten Aktuators erfasst, so wird der zweite Aktuator dazu angesteuert, die Kupplung zu öffnen, um die Wirkverbindung zu dem Substratmagazin zu lösen.

Besonders bevorzugt weist die Substrathandhabungseinheit den ersten und/oder den zweiten Aktuator auf. Damit sind bevorzugt beide Aktuatoren der Substrathandhabungseinheit zugeordnet und werden mit dieser unabhängig von dem Substratmagazin mitgeführt. Dadurch sind alle für die Verstellung der lichten Weite des Substratmagazins notwendige Aktuatoren extern ausgelagert und ein sicherer Betrieb des Substratmagazins beziehungsweise eine sichere Verwendung des Substratmagazins in dem Substratmagazinsystem gewährleistet.

Gemäß einer bevorzugten Ausführungsform der Erfindung bilden die Kupplungselemente eine Reibkupplung aus. Dazu sind die Kupplungselemente beispielsweise als Reibscheiben ausgebildet, die durch den zweiten Aktuator stirnseitig gegeneinander gepresst werden können, sodass durch Haftreibung ein Drehmoment des ersten Aktuators auf den Spindelantrieb übertragbar ist. Die Ausbildung als Reibkupplung hat den Vorteil, dass unabhängig von der Drehstellung der Kupplungselemente zueinander diese zusammengeführt werden können.

Alternativ sind die Kupplungselemente dazu ausgebildet, eine Klauenkupplung zu bilden. Dazu sind die Kupplungselemente derart gestaltet, dass sie eine formschlüssige Verbindung in Umfangsrichtung miteinander eingehen, wenn sie durch den zweiten Aktuator zusammengeschoben werden. Durch die Formschlussverbindung ist es gewährleistet, dass besonders hohe Drehmomente übertragen werden können. Nachteilig ist dabei lediglich, dass die beiden Kupplungselemente zueinander ausgerichtet werden müssen, um ein Ineinandergreifen zu ermöglichen.

Vorzugsweise ist das zweite Kupplungselement, also das mit dem ersten Aktuator dauerhaft verbundene Kupplungselement, auf der Antriebswelle drehfest und axial verschiebbar gelagert. Dadurch ist gewährleistet, dass das zweite Kupplungselement stets mit dem Drehmoment des ersten Aktuators beaufschlagbar ist, und durch axiale Verschiebung die Koppelung zu dem Substratmagazin herstellen kann. Der zweite Aktuator ist entsprechend dazu ausgebildet, das zweite Kupplungselement axial zu verschieben.

Gemäß einer bevorzugten Weiterbildung der Erfindung ist der erste Aktuator als Elektromotor ausgebildet. Dadurch ist eine präzise Einstellung des Substratmagazins durch eine elektrische/elektronische Ansteuerung mittels eines entsprechenden Steuergeräts gewährleistet. Insbesondere erlaubt der Elektromotor auf einfache Art und Weise ein Verschieben der Seitenwand in beide Schieberichtungen.

Gemäß einer bevorzugten Weiterbildung der Erfindung ist der zweite Aktuator als pneumatischer oder hydraulischer Aktuator oder als elektromotorischer oder elektromagnetischer Aktuator ausgebildet. Dadurch ist eine einfache Betätigung der Kupplung geboten. Die Ausbildung als pneumatischer Aktuator ist insbesondere dann von Vorteil, wenn die Substrathandhabungseinheit ohnehin eine Pneumatikeinrichtung aufweist, die zum Betreiben des zweiten Aktuators mitgenutzt werden kann.

Besonders bevorzugt weist die Substrathandhabungseinheit einen Lagertisch auf, auf welchem zumindest ein Substratmagazin anordenbar ist. Dadurch ist eine sichere Handhabung des Substratmagazins auf der Substrathandhabungseinheit ermöglicht. Insbesondere erlaubt der Lagertisch eine vorteilhafte Ausrichtung des Substratmagazins in Bezug auf die Aktuatoreinrichtung der Substrathandhabungseinheit, welche den ersten und den zweiten Aktuator aufweist.

Gemäß einer bevorzugten Weiterbildung der Erfindung weist der Lagertisch Führungsmittel auf, durch welche das zumindest eine Substratmagazin auf dem Lagertisch derart in eine Endlagerstellung schiebbar ist, dass die Kupplungselemente in der Endlagerstellung des Substratmagazins einander gegenüberliegen. Das Substratmagazin ist somit durch die Führungsmittel auf dem Lagertisch formschlüssig derart geführt, dass in der Endlagerstellung des Substratmagazins die Kopplung von der Aktuatoreinrichtung zu der verschiebbaren Seitenwand durch ein Ansteuern, insbesondere des zweiten Aktuators, herstellbar ist. Die Führungsmittel erlauben somit eine vorteilhafte Zuordnung der Kupplungselemente zueinander, die eine nachträgliche Ausrichtung der Aktuatoreinheit bezüglich des Substratmagazins vermeidet.

Besonders bevorzugt ist die Substrathandhabungseinheit als Be- und/oder Entladeeinrichtung für eine Fertigungslinie ausgebildet. Dazu weist die Substrathandhabungseinheit bevorzugt zumindest eine Einrichtung zum Be- und/oder Entladen von flächigen Substraten auf, die beispielsweise ein Transportband, einen Greifer, einen Schieber und/oder einen Vakuumsauger auf.

Gemäß einer weiteren Ausführungsform der Erfindung ist die Substrathandhabungseinheit bevorzugt als Transportwagen ausgebildet. Dazu weist der Transportwagen insbesondere Fortbewegungsmittel, wie einen Antriebsmotor und wenigstens drei Antriebsräder sowie Mittel zum Bremsen und zum Lenken auf. Insbesondere ist der Transportwagen als autonom fahrender Transportwagen ausgebildet, mittels dessen Substratmagazine von einem Ort zu einem anderen automatisiert verbracht werden können. Das Substratmagazinsystem umfasst besonders bevorzugt eine Vielzahl von Substratmagazinen, die wie das zuvor beschriebene Substratmagazin ausgebildet sind. Jedes Substratmagazin ist damit durch die Substrathandhabungseinheit mit Bezug auf seine lichte Weite einstellbar, sodass unabhängig von dem verwendeten Substratmagazin unterschiedliche Substrate mit unterschiedlicher Substratbreite eingesetzt werden können, indem die lichte Weite des jeweiligen Substratmagazins durch die Substrathandhabungseinheit angepasst wird.

Im Folgenden soll die Erfindung anhand der Zeichnungen näher erläutert werden. Dazu zeigen
- Figur 1: ein vorteilhaftes Substratmagazinsystem in einer vereinfachten Seitenansicht, und
- Figur 2: das Substratmagazinsystem in einer vereinfachten Draufsicht.

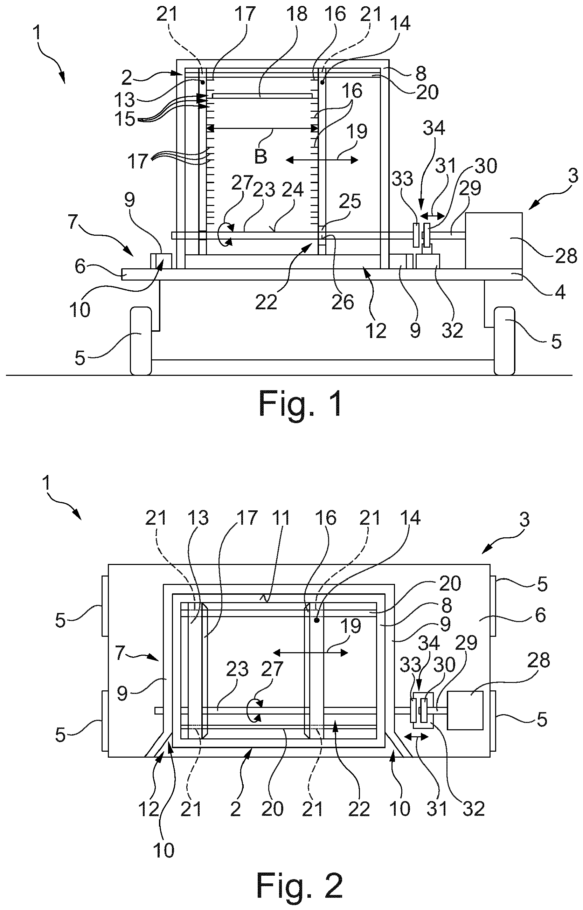

Figur 1 zeigt in einer vereinfachten Seitenansicht ein vorteilhaftes Substratmagazinsystem 1, das ein Substratmagazin 2 sowie eine Substrathandhabungseinrichtung 3 umfasst. Die Substrathandhabungseinrichtung 3 ist als Transportfahrzeug 4 ausgebildet, das gemäß dem vorliegenden Ausführungsbeispiel als autonom betriebenes Kraftfahrzeug ausgebildet ist, das mehrere antreibbare Räder 5 aufweist, von denen zumindest eins, vorzugsweise mehrere Räder lenkbar, antreibbar und/oder bremsbar sind. Alternativ kann es sich bei dem Transportfahrzeug 4 auch um ein Schienenfahrzeug handeln. Weiterhin handelt es sich gemäß einem weiteren Ausführungsbeispiel bei der Substrathandhabungseinrichtung 3 um eine Be- und Entladeeinrichtung für eine Bestückungslinie für flächige Substrate.

Die Substrathandhabungseinheit 3 weist einen Lagertisch 6 auf, auf welchem das Substratmagazin 2 angeordnet ist. Der Lagertisch 6 weist Führungsmittel 7 auf, die zur Ausrichtung und Anordnung des Substratmagazins 2 auf dem Lagertisch 6 dienen.

Figur 2 zeigt dazu das Substratmagazinsystem in einer vereinfachten Draufsicht. Das Substratmagazin 2 weist einen im Wesentlichen rechteckförmigen Rahmen 8 auf, der eine quadratische oder rechteckförmige Grundfläche aufweist. Die Führungsmittel 7 des Lagertischs 6 sind derart ausgebildet, dass sie den Rahmen 8 des Substratmagazins 2 in der gewünschten Stellung ausrichten. Dazu weisen die Führungsmittel 7 einen Führungssteg 9 auf, der sich U-förmig über den Lagertisch 6 erstreckt. Die zwei einander gegenüberliegenden Schenkel des Führungsstegs 6 sind an ihren freien Enden schräg nach außen verlaufend ausgerichtet, sodass sich eine Einführschräge für ein Substratmagazin 2 ergibt. Im Übrigen entspricht der Abstand der sich gegenüberliegenden Schenkel des U-förmig verlaufenden Führungsstegs 9 zumindest im Wesentlichen der Breite des Rahmens 8 des Substratmagazins 2, sodass das Substratmagazin 2 durch den Führungssteg ausgerichtet wird. Der die beiden gegenüberliegenden Schenkel miteinander verbindende Mittelabschnitt des Führungsstegs 9 dient als Endanschlag 11 für das Substratmagazin 2 in der durch den Führungssteg 9 gebildeten Substratmagazinaufnahme 12. Das Substratmagazin 2 ist somit maximal bis zu dem Endanschlag 11 in die Substratmagazinaufnahme 12 einschiebbar und wird durch die Führungsmittel 7 beim Einschieben darin ausgerichtet.

Das Substratmagazin 2 weist zwei an dem Rahmen 8 angeordnete Seitenwände 13, 14 auf, die beabstandet zueinander angeordnet und parallel zueinander vertikal ausgerichtet sind, wie auch in Figur 1 gezeigt. Zwischen den Seitenwänden 13, 14 ist eine Vielzahl von Schubfächern 15 ausgebildet. Jedes Schubfach 15 wird durch zwei Führungsschienen 16, 17 gebildet, die anjeweils einer der Seitenwände 14, 15 auf den einander zugewandten Seiten der jeweiligen Seitenwand 13, 14 angeordnet sind. Die Führungsschienen 16, 17 eines Schubfachs 15 liegen auf gleicher Höhe einander gegenüber derart angeordnet, dass auch zwischen den Führungsschienen 17, 16 ein Abstand verbleibt.

Ein flächiges Substrat 18, wie beispielsweise eine Leiterplatte, Solarzelle, Wafer oder dergleichen, ist in einem der Schubfächer 15 somit derart anordenbar, dass es mit seinen voneinander abgewandten Seitenrandbereichen auf jeweils einer der Führungsschienen 16, 17 aufliegt, wie in Figur 1 beispielhaft gezeigt. Aufgrund des Abstands der Führungsschienen 16, 17 zueinander bedeutet das, dass der mittlere Bereich, insbesondere der größte Bereich des jeweiligen Substrats nirgendwo aufliegt und vielmehr frei ist, sodass auch bestückte Substrate sicher in dem Substratmagazin 2 gehalten werden können, ohne dass beispielsweise auf den Substraten 18 ausgebildete Strukturen oder angeordnete elektrische/elektronische Bauteile beschädigt werden können.

Um zu erreichen, dass Substrate 18 mit unterschiedlicher Breite B in dem Substratmagazin 2 transportiert, gelagert oder zwischengelagert werden können, ist die Seitenwand 14 derart verschiebbar gelagert, wie durch einen Doppelpfeil 19 angezeigt, dass die lichte Weite zwischen den Seitenwänden 13, 14 veränderbar ist. Hierdurch ist eine Veränderung der Breite der Schubfächer 15 des Substratmagazins 2 möglich, sodass das Substratmagazin 2 an unterschiedliche zu verarbeitende Substrate anpassbar ist.

Für die verschiebbare Lagerung der Seitenwand 14 ist die Seitenwand 14 an dem Rahmen 8 verschiebbar gelagert. Dazu sind beispielsweise Führungsstangen 20 vorhanden, die in dem Rahmen 8 fest angeordnet sind, und die jeweils eine Führungsöffnung 21 der Seitenwand 14 im Wesentlichen spielfrei durchdringen. Somit ist die Seitenwand 14 entlang der Führungsstangen 20 in dem Rahmen 8 verschiebbar.

Vorteilhafterweise ist der Seitenwand 14 außerdem ein Spindelantrieb 22 zugeordnet. Der Spindelantrieb 22 weist eine Antriebsspindel 23 auf, die parallel zu den Führungsstangen 20 ausgerichtet und an dem Rahmen 8 drehbar gelagert ist. Die Antriebsspindel 23 weist ein Außengewinde 24 auf. Die Seitenwand 14 weist eine Spindelmutter 25 auf, die entweder integriert in der Seitenwand 14 ausgebildet oder als separates Bauteil an der Seitenwand 14 befestigt ist. Die Spindelmutter 25 weist ein Innengewinde 26 auf, das mit dem Außengewinde 24 der Antriebsspindel 23 in Eingriff steht. Wird nunmehr die Antriebsspindel 23 in Rotationsbewegung gemäß Doppelpfeil 27 versetzt, so wird die Rotationsbewegung der Antriebsspindel 23 in eine Translationsbewegung der Seitenwand 14 gemäß Doppelpfeil 19 gewandelt und die lichte Weite zwischen den Seitenwänden 13, 14 durch das Verschieben der Seitenwand 14 verändert.

Die Substrathandhabungseinheit 3 weist dazu einen ersten Aktuator 28 auf, der dazu ausgebildet ist, die Antriebsspindel 20 anzutreiben. Der Aktuator 28 ist als Elektromotor ausgebildet, der eine Antriebswelle 29 aufweist. An einem freien Ende der Antriebswelle 29 ist ein Kupplungselement 30 angeordnet. Das Kupplungselement 30 ist drehfest mit der Antriebswelle 29 verbunden und axial auf dieser verschiebbar gelagert, wie durch einen Doppelpfeil 31 gezeigt. Dem Kupplungselement 30 ist ein zweiter Aktuator 32 zugeordnet, der dazu ausgebildet ist, das Kupplungselement 30 axial entlang der Antriebswelle 29 zu verschieben, ohne dabei dessen Drehbewegung oder Verdrehung zu behindern. Der zweite Aktuator ist dabei insbesondere als pneumatischer oder hydraulischer Aktuator 32 ausgebildet.

Die Antriebsspindel 23 weist an einem freien Ende ein zweites Kupplungselement 33 auf, das drehfest und insbesondere auch axial fest an der Antriebsspindel 23 angeordnet ist. Die Kupplungselemente 30 und 33 sind durch das Verlagern des Kupplungselements 30 in Wirkverbindung miteinander bringbar. Dabei sind die Kupplungselemente 30, 33 dazu ausgebildet, eine Kupplung 34 zwischen dem Aktuator 28 und dem Spindelantrieb 22 zu bilden. In der Endlagerstellung des Substratmagazins 2 in der Substratmagazinaufnahme 12 liegt das Kupplungselement 33 dem Kupplungselement 30 gegenüber, sodass durch ein einfaches axiales Verlagern des Kupplungselements 30 die Wirkverbindung mittels des zweiten Aktuators 32 herstellbar ist.

Somit erlaubt die vorteilhafte Ausbildung des Substratmagazinsystems 1, dass die lichte Weite der Schubfächer 15 des Substratmagazins 2 anpassbar ist, ohne dass das Substratmagazin 2 selbst einen hierfür notwendigen Aktuator aufweisen muss. Vielmehr ist der Aktuator 28 ortsfest oder lokal an der Substrathandhabungseinrichtung 3 angeordnet und durch die Kupplung 34 mit dem Substratmagazin 2 wirkverbindbar. Die Führungsmittel 7 sorgen dabei dafür, dass eine einfache Positionierung des Kupplungselements 33 gegenüber dem Kupplungselement 30 gewährleistet ist. Somit erfolgt eine automatische Ausrichtung durch die Führungsmittel 7 beim Einschieben des Substratmagazins 2 in die Substratmagazinaufnahme 12.

Vorteilhafterweise sind die Kupplungselemente 30, 33 dazu ausgebildet, eine Reibkupplung auszubilden, sodass eine besonders präzise Verstellung der Seitenwand 14 mittels Haftreibung zwischen den Kupplungselementen 30, 33 erzielt wird. Die Kupplungselemente 30, 33 sind dazu insbesondere als Reibscheiben ausgebildet. Alternativ kann die Kupplung 34 aber auch als Klauenkupplung ausgebildet sein, die eine formschlüssige Verbindung zur Übertragung des Antriebsdrehmoments des Aktuators 28 auf den Spindelantrieb 23 ermöglicht.

Das Substratmagazinsystem 1 weist vorteilhafterweise eine Vielzahl von Substratmagazinen 2 auf, die wie vorstehend beschrieben ausgebildet sind. Somit können die Substratmagazine 2 jeweils in der Substratmagazinaufnahme 12 angeordnet und mittels der Aktuatoren 28, 32 auf eine gewünschte Substratbreite angepasst beziehungsweise eingestellt werden.

Durch den Spindelantrieb 23 ist gewährleistet, dass ein versehentliches Verschieben der Seitenwand 14, ohne dass der Spindelantrieb 22 angetrieben wird, verhindert ist. Hierfür sorgt die selbsthemmende Wirkung des Spindelantriebs 22.

## Patentansprüche

1. Substratmagazinsystem (1) für Be- oder Entladeeinrichtungen von Fertigungslinien, mit zumindest einem Substratmagazin (2), das zwei beabstandet zueinander angeordnete und parallel zueinander ausgerichtete Seitenwände (13,14) aufweist, zwischen denen eine Vielzahl von Schubfächern (15) übereinanderliegend ausgebildet ist, wobei die Schubfächer (15) jeweils zur Lagerung einer oder mehrerer flächiger Substrate (18) ausgebildet sind, und wobei jedes Schubfach (15) durch jeweils zwei Führungsschienen (16,17) ausgebildet ist, die an den Seitenwänden (13,14) beabstandet zueinander einander gegenüberliegend angeordnet sind, wobei zumindest eine der Seitenwände (14) zum Verändern der lichten Weite zwischen den Seitenwänden (13,14) verschiebbar gelagert ist, und mit zumindest einer Substrathandhabungseinrichtung (3) in, an oder auf welcher das zumindest eine Substratmagazin (2) zur Handhabung von Substraten (18) anordenbar ist, **dadurch gekennzeichnet, dass** die Substrathandhabungseinrichtung (3) einen ersten Aktuator (28) aufweist, der mit der verschiebbar gelagerten Seitenwand (14) durch eine betätigbare Kupplung (34) koppelbar und dazu ausgebildet ist, die verschiebbare Seitenwand (14) im gekoppelten Zustand zu verschieben.

2. Substratmagazinsystem nach Anspruch 1, **dadurch gekennzeichnet, dass** das Substratmagazin (2) einen der verschiebbar gelagerten Seitenwand (14) zugeordneten Spindelantrieb (22) aufweist, der durch die Kupplung (34) mit dem ersten Aktuator (28) koppelbar ist.

3. Substratmagazinsystem nach einem der vorhergehenden Ansprüche, **dadurch gekennzeichnet, dass** der Spindelantrieb (22) eine Antriebsspindel (23) aufweist, die an einem freien Ende ein erstes Kupplungselement (33) aufweist, und dass der erste Aktuator (28) eine Antriebswelle (29) aufweist, die an einem freien Ende ein zweites Kupplungselement (30) aufweist, wobei das erste und das zweite Kupplungselement (30) zusammen die betätigbare Kupplung (34) ausbilden.

4. Substratmagazinsystem nach einem der vorhergehenden Ansprüche, **dadurch gekennzeichnet, dass** zumindest eines der Kupplungselemente (30) zum Herstellen oder Lösen der Koppelung verlagerbar ausgebildet ist.

5. Substratmagazinsystem nach einem der vorhergehenden Ansprüche, **dadurch gekennzeichnet, dass** dem verlagerbaren Kupplungselement (30) ein zweiter Aktuator (32) zu dessen Verlagerung zugeordnet ist.

6. Substratmagazinsystem nach einem der vorhergehenden Ansprüche, **dadurch gekennzeichnet, dass** die Substrathandhabungseinheit (3) den ersten und/oder zweiten Aktuator (32) aufweist.

7. Substratmagazinsystem nach einem der vorhergehenden Ansprüche, **dadurch gekennzeichnet, dass** die Kupplungselemente (30,33) eine Reibkupplung ausbilden.

8. Substratmagazinsystem nach einem der vorhergehenden Ansprüche, **dadurch gekennzeichnet, dass** die Kupplungselemente (30,33) einen Klauenkupplung ausbilden.

9. Substratmagazinsystem nach einem der vorhergehenden Ansprüche, **dadurch gekennzeichnet, dass** das zweite Kupplungselement (30) auf der Antriebswelle (29) drehfest und axial verschiebbar gelagert ist.

10. Substratmagazinsystem nach einem der vorhergehenden Ansprüche, **dadurch gekennzeichnet, dass** der erste Aktuator (28) als Elektromotor ausgebildet ist.

11. Substratmagazinsystem nach einem der vorhergehenden Ansprüche, **dadurch gekennzeichnet, dass** die Substrathandhabungseinheit (3) einen Lagertisch (6) aufweist, auf welchem zumindest ein Substratmagazin (2) anordenbar ist.

12. Substratmagazinsystem nach einem der vorhergehenden Ansprüche, **dadurch gekennzeichnet, dass** der Lagertisch (6) Führungsmittel (7) aufweist, durch welche das zumindest eine Substratmagazin (2) auf dem Lagertisch (6) derart in eine Endlagerstellung geführt wird, in welcher die Kupplungselemente (30,33) des Substratmagazins (2) einander gegenüberliegen.

13. Substratmagazinsystem nach einem der vorhergehenden Ansprüche, **dadurch gekennzeichnet, dass** die Substrathandhabungseinheit (3) als Be- und/oder Entladeeinrichtung für eine Fertigungslinie ausgebildet ist.

14. Substratmagazinsystem nach einem der vorhergehenden Ansprüche, **dadurch gekennzeichnet, dass** die Substrathandhabungseinheit (3) als Transportwagen ausgebildet ist.
